(19) Europäisches Patentamt / European Patent Office / Office européen des brevets

(11) EP 4 636 802 A1

(12) EUROPEAN PATENT APPLICATION
published in accordance with Art. 153(4) EPC

(43) Date of publication:
22.10.2025 Bulletin 2025/43

(21) Application number: 23924245.6

(22) Date of filing: 20.12.2023

(51) International Patent Classification (IPC):
H01J 37/244 (2006.01)    H01J 43/24 (2006.01)

(52) Cooperative Patent Classification (CPC):
H01J 37/244; H01J 43/24

(86) International application number:
PCT/JP2023/045781

(87) International publication number:
WO 2024/176601 (29.08.2024 Gazette 2024/35)

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
KH MA MD TN

(30) Priority: 22.02.2023 JP 2023026147

(71) Applicant: Hamamatsu Photonics K.K.
Hamamatsu-shi, Shizuoka 435-8558 (JP)

(72) Inventor: HAYASHI, Masahiro
Hamamatsu-shi, Shizuoka 435-8558 (JP)

(74) Representative: Grünecker Patent- und
Rechtsanwälte
PartG mbB
Leopoldstraße 4
80802 München (DE)

(54) **MCP DETECTOR AND ANALYSIS DEVICE**

(57) An MCP detector 1 includes: an MCP 3 including an input surface 3a to which an electron e1 is input, multipliers 11A and 11B, each being configured to multiply an electron generated in response to an input of the electron e1, and an output surface 3b from which electrons e2 resulting from multiplication by the multipliers 11A and 11B are output; a dynode 5 disposed so as to be separated from the output surface 3b and substantially parallel to the output surface 3b, and configured to multiply the electrons e2 output from the output surface 3b, the dynode 5 being in a planar shape; and an electron collection unit 7 disposed between the output surface 3b and the dynode 5 so as to be separated from the output surface 3b and the dynode 5, and configured to collect electrons e3 resulting from multiplication by the dynode 5, in which the electron collection unit 7 includes a wire anode 7a including a metal wire extending along a plane substantially parallel to the output surface 3b, and a wire anode 7b electrically insulated from the wire anode 7a, including a metal wire extending along the plane, and disposed between the wire anode 7a and the dynode 5.

Fig.1

EP 4 636 802 A1

## Description

## Technical Field

One aspect of an embodiment relates to an MCP detector and an analysis device.

## Background Art

It is demanded for an analysis device such as an X-ray photoelectron spectroscopy (XPS) including a microchannel plate (MCP) to improve output linearity of the microchannel plate. Although it has been studied to reduce the resistance of the microchannel plate in order to improve the output linearity of the microchannel plate, the improvement of the output linearity by reducing the resistance has already approached the limit.

Conventionally, a triode structure in which an anode and a dynode are combined with a microchannel plate has been studied. As a conventional charged particle detector including a triode structure, for example, an electron multiplier device described in Patent Literature 1 below is known. This electron multiplier device includes an MCP, and a dynode and a grid-like anode disposed parallel to an output surface of the MCP.

## Citation List

## Patent Literature

Patent Literature 1: Japanese Unexamined Patent Publication No. S57-196466

## Summary of Invention

## Technical Problem

In the above-described conventional electron multiplier device, the detection performance of the detector in which the MCP is mounted has peaked due to the limit of the output linearity specific to the MCP. Therefore, there is a demand to improve the detection performance of the detector in which the MCP is mounted.

Therefore, one aspect of the embodiments has been made in view of such a problem, and an objective thereof is to provide an analysis device and an MCP detector capable of improving detection performance of the detector in which an MCP is mounted.

## Solution to Problem

An MCP detector according to a first aspect of an embodiment includes: a microchannel plate including an input surface to which a charged particle is input, a multiplier configured to multiply an electron generated in response to an input of the charged particle, and an output surface from which electrons resulting from multiplication by the multiplier are output; a dynode disposed so as to be separated from the output surface and substantially parallel to the output surface, and configured to multiply the electrons output from the output surface, the dynode being in a planar shape; and an electron collection unit disposed between the output surface and the dynode so as to be separated from the output surface and the dynode, and configured to collect electrons resulting from multiplication by the dynode, in which the electron collection unit includes a first anode including a metal wire extending along a plane substantially parallel to the output surface, and a second anode electrically insulated from the first anode, including a metal wire extending along the plane, and disposed between the first anode and the dynode.

Alternatively, an analysis device according to a second aspect of the embodiment includes the above-described MCP detector.

According to the first aspect or the second aspect, among the electrons output from the output surface of the microchannel plate (hereinafter, it is also referred to as "MCP") in response to the charged particles input to the input surface of the MCP, the electrons having passed through the first anode and the second anode are multiplied by the dynode, and electrons resulting from multiplication captured by the second anode and the first anode. As a result, the number of electrons obtained through multiplication of the output electrons of the MCP can be reflected to the output signal on the basis of the electrons acquired by the first anode and the second anode. As a result, the output linearity of the entire MCP detector can be improved. As a result, the detection performance of the MCP detector or the analysis device including the MCP detector can be improved.

## Advantageous Effects of Invention

According to any aspect of the present disclosure, it is possible to improve the detection performance of the detector in which the MCP is mounted.

## Brief Description of Drawings

FIG. 1 is a cross-sectional view illustrating a configuration of an MCP detector 1 according to an embodiment.
FIG. 2 is a plan view illustrating a specific configuration of wire anodes 7a and 7b.
FIG. 3 is a cross-sectional view illustrating support structures of an electron collection unit 7.
FIG. 4 is a cross-sectional view illustrating a multiplication state of secondary electrons in one channel of multipliers 11A and 11B of an MCP 3 in which potentials are set by a control unit 9.
FIG. 5 is a diagram for explaining a method of calculating an input position by a signal processing unit 9a on the basis of pulse signals output from the wire anodes 7a and 7b.

FIG. 6 is a diagram illustrating a display example of an image generated by the signal processing unit 9a.

FIG. 7 is a diagram illustrating a display example of an image generated by the signal processing unit 9a.

FIG. 8 is a graph illustrating the pulse-height distribution used to measure the gain in the MCP detector 1.

FIG. 9 is a graph illustrating the measurement result of the gain in each electrode when a potential of the wire anode 7b is changed in the MCP detector 1.

FIG. 10 is a graph illustrating the measurement result of the gain in the MCP detector 1.

FIG. 11 is a graph illustrating the measurement result of the gain in the MCP detector 1.

FIG. 12 is a plan view illustrating a configuration of a modification of the electron collection unit.

**Description of Embodiments**

Hereinafter, the embodiments of the present invention will be described in detail with reference to the accompanying drawings. Note that, in the description, the same reference numerals will be used for the same elements or elements having the same functions, and redundant description will be omitted.

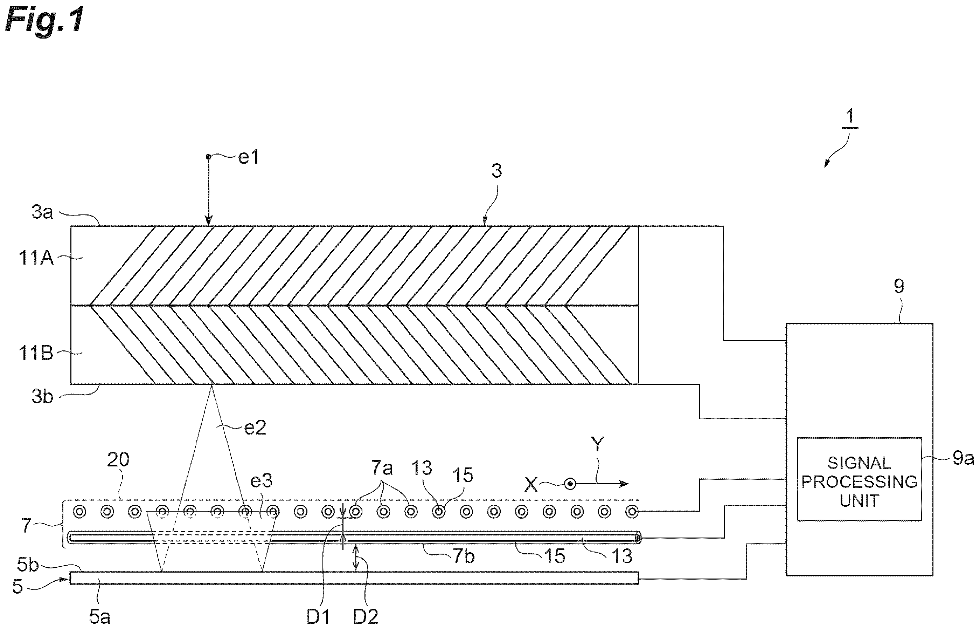

FIG. 1 is a cross-sectional view illustrating a configuration of an MCP detector 1 according to an embodiment. In FIG. 1, the circuit section is illustrated by a block. The MCP detector 1 is a device that detects charged particles to be input. In the present embodiment, the MCP detector 1 detects a two-dimensional position of input charged particles. The charged particles to be detected may include electrons, ions, or the like. In the present embodiment, electrons are exemplified as detection targets of the MCP detector 1.

As illustrated in FIG. 1, the MCP detector 1 includes an MCP 3, a dynode 5, an electron collection unit 7, and a control unit 9. The MCP 3, the dynode 5, and the electron collection unit 7 are formed in a substantially planar shape as a whole, and are disposed to be substantially parallel to one another. Hereinafter, a configuration of each component of the MCP detector 1 will be described.

The MCP 3 includes an input surface 3a to which electrons are input, a pair of multipliers 11A and 11B that perform multiplication of secondary electrons (secondary electron multiplication) generated in response to the input of the electrons while maintaining a two-dimensional position of the electrons with respect to the input surface 3a, and an output surface 3b from which the electrons multiplied by the multipliers 11A and 11B are output. Each of the multipliers 11A and 11B is a secondary electron multiplier having a plurality of microchannel structures independent from one another. In the multipliers 11A and 11B, a plurality of microchannel structures are two-dimensionally disposed.

Each channel of the multipliers 11A and 11B has an inner diameter of about 10 $\mu$m and is inclined by about 10 degrees with respect to the normal direction (electron input direction) of the input surface 3a. The inclination direction of the channels of the multiplier 11A and the inclination direction of the channels of the multiplier 11B are reversed from each other. In the multipliers 11A and 11B, the output surface 3b side is set to a higher potential with respect to the input surface 3a side. Secondary electrons generated upon the arrival of electrons to the input surface 3a are multiplied by the multipliers 11A and 11B, and the secondary electrons resulting from multiplication are output from the output surface 3b.

The dynode 5 is an electrode that multiplies the electrons output from the MCP 3. The dynode 5 is a substantially flat plate-shaped electrode disposed substantially parallel to the output surface 3b so as to be separated from the output surface 3b of the MCP 3. That is, the dynode 5 includes a support member 5a that contains a metal material such as flat-shaped stainless steel (SUS) and a secondary electron-emitting film 5b formed on a surface of the support member 5a close to the MCP 3. The secondary electron-emitting film 5b contains, for example, a secondary electron-emitting material such as Al2O3, BeO, LiF, MgF2, MgO, CsBr, NaCl, or crystalline diamond. In addition, the support member 5a may be formed by stacking a conductor layer on a flat plate-shaped member containing an insulator material, and in this case, the secondary electron-emitting film 5b is formed on the conductor layer of the support member 5a.

The electron collection unit 7 is an electrode that is disposed between the output surface 3b of the MCP 3 and the dynode 5 so as to be separated from the MCP 3 and the dynode 5, and collects (captures) electrons resulting from multiplication by the secondary electron-emitting film 5b of the dynode 5 and emitted toward the output surface 3b. The electron collection unit 7 is disposed closer to the dynode 5 than a central position between the output surface 3b and the dynode 5. The electron collection unit 7 includes a wire anode (first anode) 7a that extends in a first direction X along a plane substantially parallel to the output surface 3b, and a wire anode (second anode) 7b that is electrically insulated from the wire anode 7a, extends in a second direction Y substantially perpendicular to the first direction X along the plane substantially parallel to the output surface 3b, and is disposed between the wire anode 7a and the dynode 5.

Each of the wire anodes 7a and 7b is formed by applying an antioxidant coating (gold plating) 15 to a thin metal wire (metal wire) 13 made of copper, nickel, chromium, SUS, or the like. For example, each of the wire anodes 7a and 7b has a line width within a range of 50 $\mu$m or more and 200 $\mu$m or less. The wire anodes 7a extend in the direction X at a plurality of positions with a predetermined interval (for example, an interval of 200 $\mu$m or more and 1 mm or less) in the direction Y, and are electrically connected as a whole. The wire anodes 7b extend in the direction Y at a plurality of positions with a predetermined interval (for example, for example, an interval of 200 μm or more and 1 mm or less) in the direction X, and are electrically connected as a whole. In other words, the wire anodes 7a extend in a direction substantially perpendicular to a direction in which the wire anodes 7b extend on the plane substantially parallel to the output surface 3b, and the wire anodes 7a and the wire anodes 7b are disposed separately in a direction perpendicular to the output surface 3b.

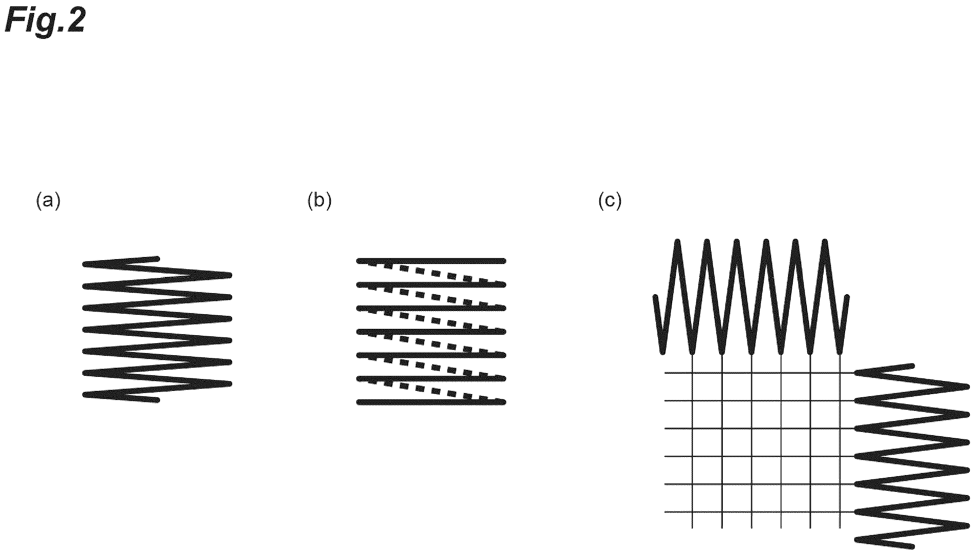

FIG. 2 is a plan view illustrating a specific configuration of the wire anodes 7a and 7b. As illustrated in part (a) of FIG. 2, each of the wire anodes 7a and 7b may have a configuration in which a thin metal wire is disposed in a zigzag pattern bridging between a pair of facing edges of a frame-shaped support member having insulating properties (not illustrated). In this case, both ends of the thin metal wire are electrically connected to the control unit 9. As illustrated in part (b) of FIG. 2, each of the wire anodes 7a and 7b may also have a configuration in which a thin metal wire is wound around a pair of facing edges of a frame-shaped support member having insulating properties (not illustrated) so as not to overlap each other. In this case, both ends of the thin metal wire are also electrically connected to the control unit 9. As illustrated in part (c) of FIG. 2, the wire anodes 7a and 7b may have a configuration in which a plurality of linear thin metal wires are disposed at a predetermined interval, the plurality of linear thin metal wires are electrically connected to each other by zigzag metal patterns, and the linear thin metal wire constituting each wire anode 7a and the linear thin metal wire constituting each wire anode 7b are electrically insulated from each other with an insulating member (not shown) interposed therebetween. In this case, both ends of the zigzag metal pattern of each of the wire anodes 7a and 7b are electrically connected to the control unit 9.

Here, a distance D2 between the wire anode 7b and the dynode 5 is set to be larger than a distance D1 between the wire anode 7a and the wire anode 7b. In addition, the electron collection unit 7 including the wire anode 7a and the wire anode 7b is disposed, as a whole, closer to the dynode 5 than a virtual plane 20 corresponding to an intermediate position between an intermediate position between the output surface 3b and the secondary electron-emitting film 5b of the dynode 5, and the secondary electron-emitting film 5b of the dynode 5.

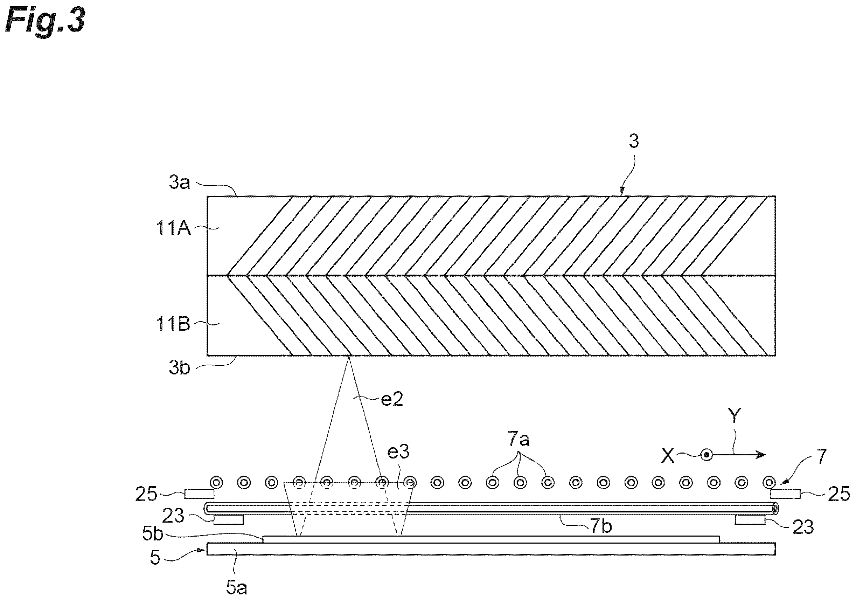

Support structures of the electron collection unit 7 will be described with reference to FIG. 3. FIG. 3 is a cross-sectional view illustrating support structures of the electron collection unit. The electron collection unit 7 includes support members 23 that support the wire anode 7b and made of an insulating material, and support members 25 that support the wire anode 7a and made of an insulating material. The support members 23 and 25 are provided to be positioned outside a region where the secondary electron-emitting film 5b is provided on the surface of the dynode 5 closer to the MCP 3 when the dynode 5 is viewed from the output surface 3b. Note that a common member may be used as the support members 23 and the support members 25.

The control unit 9 is a circuit that is electrically connected to the input surface 3a and the output surface 3b of the MCP 3, the dynode 5, and the wire anodes 7a and 7b of the electron collection unit 7, and that sets each potential and processes pulse signals output from the wire anodes 7a and 7b. In the control unit 9, a signal processing unit 9a is incorporated, the signal processing unit 9a processing the pulse signals output from the wire anodes 7a and 7b and generating an image representing a two-dimensional position of electrons input to the input surface 3a of the MCP 3.

That is, the control unit 9 applies a voltage to the input surface 3a, the output surface 3b, the dynode 5, and the wire anodes 7a and 7b so that a potential of the output surface 3b is higher than a potential of the input surface 3a, a potential of the dynode 5 is higher than the potential of the output surface 3b, a potential of the electron collection unit 7 is higher than the potential of the dynode 5, and a potential of the wire anode 7a is higher than a potential of the wire anode 7b. In other words, the control unit 9 sets each of the potentials so that the potentials of the input surface 3a, the output surface 3b, the dynode 5, the wire anode 7b, and the wire anode 7a increase in this order. For example, assuming that the potential of the input surface 3a is 0 V, the control unit 9 sets the potential of the output surface 3b to +1,920 V, the potential of the dynode 5 to +2,112 V, the potential of the wire anode 7a to +2,400 V, and the potential of the wire anode 7b to a potential higher than +2,112 V and lower than +2,400 V.

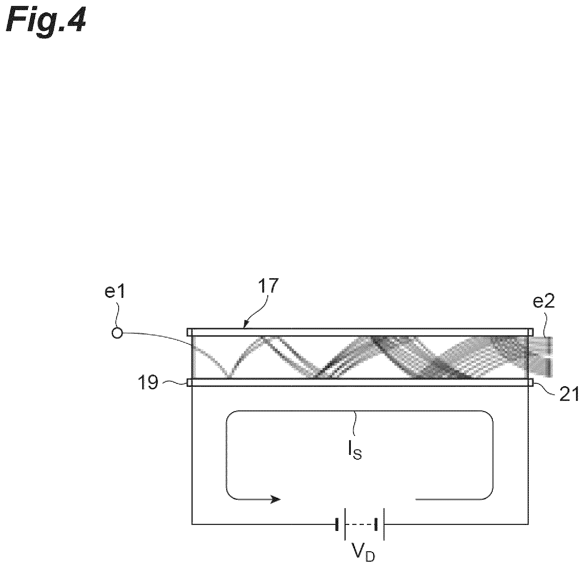

FIG. 4 is a cross-sectional view illustrating a multiplication state of secondary electrons in one channel of the multipliers 11A and 11B of the MCP 3 in which potentials are set by the control unit 9. An electrode 19 is provided at an end portion of the channel 17 on the input surface 3a side of the multipliers 11A and 11B, an electrode 21 is provided at an end portion of the channel 17 on the output surface 3b side of the multipliers 11A and 11B, and the electrode 21 of each channel 17 of the multiplier 11A and the electrode 19 of each channel 17 of the multiplier 11B are electrically connected. The control unit 9 supplies a voltage such that the potential of the electrode 19 becomes lower between the electrode 19 of the multiplier 11A and the electrode 21 of the multiplier 11B. As a result, a voltage $V_D$ is applied between both end portions of the channel 17 of each of the multipliers 11A and 11B, and a strip current Is is generated from the end portion on the output surface 3b side toward the end portion on the input surface 3a side in an inner wall portion of the channel 17. In a case where an electron e1 is input from the end portion of the channel 17 on the input surface 3a side in such a state, the electron e1 collides with the inner wall portion of the channel 17, resulting in multiplication of electrons, and secondary electrons e2 generated by repeating the multiplication of electrons in the inner wall portion of the channel 17 are output from the end portion of the channel 17 on the output surface 3b side. The output electrons of the multipliers 11A and 11B are generated by extracting a part of the strip current $I_S$, and the output linearity of the MCP3 is thus about 7% of the value of the strip current $I_S$. For this reason, it is necessary to lower a resistance value of the inner wall portion of the channel 17 in order to improve the output linearity of the MCP3 itself. Note that the output linearity means the upper limit of the number of output electrons per time during which electrons can be output while retaining a linear relationship between the number of input electrons and the number of output electrons.

The signal processing unit 9a of the control unit 9 processes the pulse signals output from both ends of the two wire anodes 7a and 7b in response to the electrons collected by the wire anodes 7a and 7b, and generates an image representing the two-dimensional coordinates of the input position of the electrons to the input surface 3a of the MCP 3.

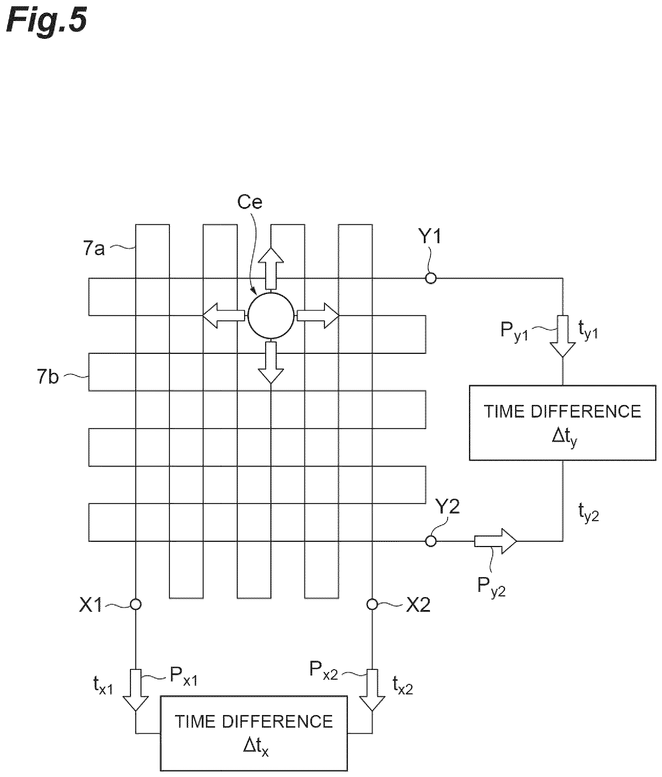

FIG. 5 is a diagram for explaining a method of calculating an input position by the signal processing unit 9a on the basis of pulse signals output from the wire anodes 7a and 7b. In a case where an output electron cloud Ce from the MCP 3 is captured by two wire anodes 7a and 7b, while propagating a pulse signal $P_{x1}$ corresponding to the captured amount in the wire anode 7a from a position of the output electron cloud Ce to one end X1 of the wire anode 7a, a pulse signal $P_{x2}$ corresponding to the captured amount is propagated from the position of the output electron cloud Ce to the other end X2 of the wire anode 7a. Concurrently, a pulse signal Py1 corresponding to the captured amount in the wire anode 7b is propagated from the position of the output electron cloud Ce to one end Y1 of the wire anode 7b, and at the same time, a pulse signal Py2 corresponding to the captured amount is propagated from the position of the output electron cloud Ce to the other end Y2 of the wire anode 7b.

The signal processing unit 9a detects the pulse signals $P_{x1}$, $P_{x2}$, $P_{y1}$, and $P_{y2}$ at a predetermined counting rate, and calculates two-dimensional coordinates (x,y) indicating the input position of the output electron cloud Ce using the propagation time difference by the following Equations (1) and (2) on the basis of detection timings $t_{x1}$, $t_{x2}$, $t_{y1}$, and $t_{y2}$ of the pulse signals. Here, $C_x$ and $C_y$ are predetermined constants.

$$x = C_x \cdot (t_{x1} - t_{x2}) \quad ...(1)$$

$$y = C_y \cdot (t_{y1} - t_{y2}) \quad ...(2)$$

The counting rate of the calculation of the two-dimensional coordinates in the signal processing unit 9a is set in advance to such a value that the next output electron cloud is not captured during the detection of one output electron cloud Ce according to the characteristics of the MCP3.

In addition, the signal processing unit 9a calculates the two-dimensional histogram by counting the two-dimensional coordinates calculated by the above-described method during a predetermined time, and generates an image representing the calculated two-dimensional histogram. With this image, it is possible to grasp the two-dimensional position distribution of the electrons input to the MCP 3 within the predetermined time.

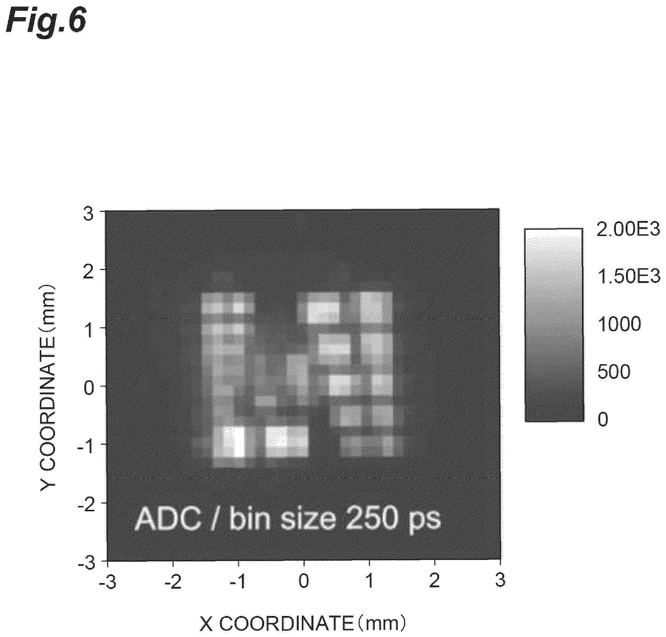

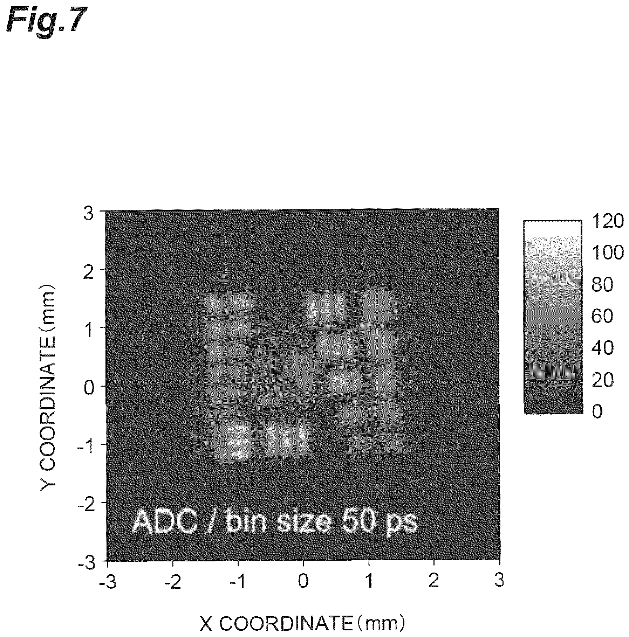

FIGS. 6 and 7 are diagrams, each illustrating a display example of an image generated by the signal processing unit 9a. FIG. 6 illustrates an image display example in a case where a two-dimensional histogram is generated with a bin size of 250 ps (picoseconds), and FIG. 7 illustrates an image display example in a case where one-dimensional histogram is generated with a bin size of 50 ps. In this manner, the larger the bin size, the larger the count number, and the smaller the bin size, the higher the resolution of the image.

Next, an analysis device according to an embodiment will be described. The analysis device according to the embodiment includes the above-described MCP detector 1. For example, the analysis device is an X-ray photoelectron spectroscopy (XPS), a photoemission electron microscopy (PEEM), an atom probe tomography (APT), a secondary ion mass spectroscopy (SIMS), or the like.

Functions and effects of the present embodiment will be described.

In the MCP detector 1 and the analysis device including the MCP detector 1 according to the present embodiment, electrons passing through the wire anode 7a and the wire anode 7b, among the electrons e2 output from the output surface 3b in response to the electrons e1 input to the input surface 3a, are multiplied by the dynode 5, and electrons e3 resulting from multiplication are captured by the wire anode 7b and the wire anode 7a. As a result, the number of electrons obtained through multiplication of the output electrons of the MCP 3 can be reflected to the pulse signal on the basis of the electrons acquired by the wire anode 7a and the wire anode 7b. As a result, the output linearity of the entire MCP detector can be improved. As a result, the detection performance of the MCP detector 1 or the analysis device including the MCP detector 1 can be improved.

The detection performance of a conventional analysis device in which an MCP detector such as an XPS device is mounted is limited by the output linearity specific to the MCP. In recent years, in the XPS device, throughput has been improved by increasing brightness of an X-ray probe, taking measures against electrostatic charge, and the like. Therefore, in a case where the counting rate of the MCP detector can be increased, the throughput of the entire analysis device can be improved. The output linearity of the MCP detector is expressed by a product of the MCP gain and the counting rate, and the MCP gain and the counting rate are in a trade-off relationship. In addition, the output linearity specific to the MCP incorporated in the MPC detector is improved by lowering the resistance of channels of the MCP; however, in the current situation, there is a limit to lowering the resistance from the viewpoint of maintaining the performance of the MCP when heated. According to the present embodiment, since the output linearity of the MCP detector is improved, the counting rate can be improved while maintaining the MCP gain. The number of wire anodes spanned by the input electron cloud can be retained by maintaining the MCP gain, and the resolution (positional accuracy or spatial resolution) in the image representing the two-dimensional coordinates of the electrons generated by the MCP detector can be maintained.

In the present embodiment, the potential of the dynode 5 is higher than the potential of the output surface 3b, and the potential of the electron collection unit 7 is higher than the potential of the dynode 5. With this setting, the electrons e2 output from the output surface 3b can efficiently reach the dynode 5, and the electrons e3 resulting from multiplication by the dynode 5 can be efficiently captured by the electron collection unit 7. As a result, the output linearity of the MCP detector can be improved, and the detection performance of the MCP detector 1 or the analysis device including the MCP detector 1 can be significantly improved.

In addition, in the present embodiment, the potential of the wire anode 7a is higher than the potential of the wire anode 7b. In this case, the electrons e3 resulting from multiplication by the dynode 5 can be captured by the wire anode 7a and the wire anode 7b in a well-balanced manner. As a result, the detection performance of the MCP detector 1 or the analysis device including the MCP detector 1 can be improved in a well-balanced manner. In particular, the number of electrons acquired by the wire anode 7a and the number of electrons acquired by the wire anode 7b based on the input electron cloud can be 1:1, and distortion in the X-coordinate direction or the Y-coordinate direction in the image representing the two-dimensional coordinates of the electrons generated by the MCP detector can be reduced.

In addition, in the present embodiment, the wire anode 7a includes the thin metal wire 13 extending in the first direction X along the plane, and the wire anode 7b includes the thin metal wire 13 extending in the second direction Y intersecting the first direction X along the plane. In this case, position information of the input electrons can be accurately acquired on the basis of two pulse signals generated by the wire anode 7a and the wire anode 7b.

In addition, in the present embodiment, the distance D2 between the wire anode 7b and the dynode 5 is set to be larger than the distance D1 between the wire anode 7a and the wire anode 7b. In a case where a potential difference between the two wire anodes 7a and 7b is V1 and a potential difference between the wire anode 7b and the dynode 5 is V2, V1 needs to be set to several tens of volts, and V2 needs to be set to 100 to 500 V, leading to V1 < V2. This is because it is necessary to increase the potential difference Va between the output surface 3b and the dynode 5 in order to increase the total gain, and it is necessary to set $V2 \approx Va$ in order to increase the gain of the dynode 5. In this case, the distance between the electron collection unit 7 and the dynode 5 can be ensured, and the withstand voltage can be increased even when the potential difference between the electron collection unit 7 and the dynode 5 is set high in order to increase the gain in the dynode 5.

In addition, in the present embodiment, the electron collection unit 7 is disposed, as a whole, closer to the dynode 5 than the virtual plane 20. In this way, the incidence efficiency (transmittance) of the electrons output from the output surface 3b of the MCP 3 to the dynode 5 is improved, and the detection performance of the MCP detector 1 can be further improved.

In addition, in the present embodiment, the electron collection unit 7 further includes the support members 23 having insulating properties and supporting the wire anode 7b, and the support members 23 are provided outside, as viewed from the output surface 3b, the region where the secondary electron-emitting film 5b is provided on the surface of the dynode 5. In a case where such a configuration is adopted, the collection efficiency of the electrons e3 multiplied and diffused by the dynode 5 can be improved in the electron collection unit 7, and the detection performance of the MCP detector 1 can be further improved.

In addition, in the present embodiment, the electron collection unit 7 further includes the support members 25 having insulating properties and supporting the wire anode 7a, and the support members 25 are provided outside, as viewed from the output surface 3b, of the region where the secondary electron-emitting film 5b is provided on the surface of the dynode 5. In a case where such a configuration is adopted, the collection efficiency of the electrons e3 multiplied and diffused by the dynode 5 can be improved in the electron collection unit 7, and the detection performance of the MCP detector 1 can be further improved.

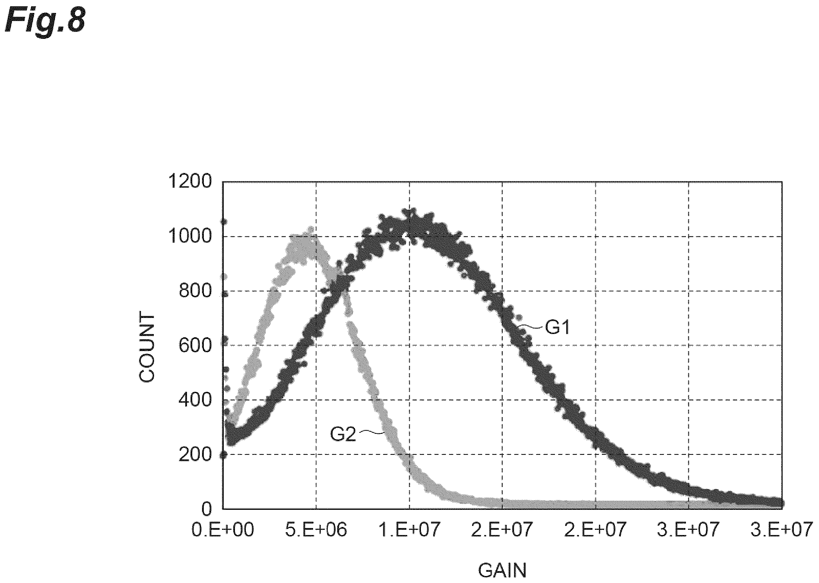

FIG. 8 is a graph illustrating the pulse-height distribution used to measure the gain in the MCP detector 1. In the graph illustrated in FIG. 8, the horizontal axis represents the gain, and the vertical axis represents the number of detection counts. The gain is the number of electrons included in one count of a pulse signal, and is defined as a peak position of the pulse-height distribution. A graph G1 indicates measurement results for the wire anodes 7a and 7b in the present embodiment, and a graph G2 indicates measurement results in a comparative example in which pulse signals are summed up in a case where the dynode 5 and the wire anodes 7a and 7b are set to the same potential in the MCP detector 1. From these measurement results, it can be seen that the gain corresponding to the peak of the pulse height distribution in the present embodiment is improved by about a factor of two compared to the comparative example.

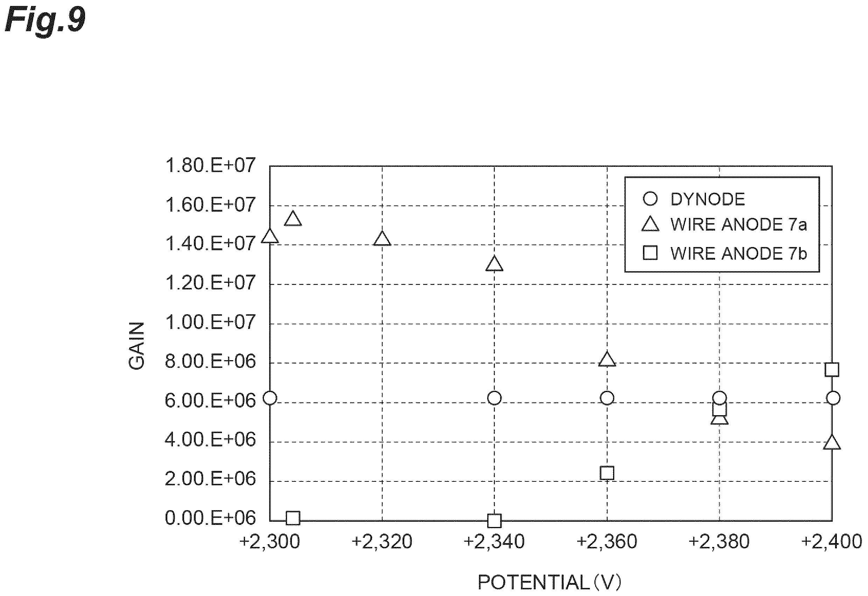

FIG. 9 is a graph illustrating the measurement result of the gain in each electrode when the potential of the wire anode 7b is changed in the MCP detector 1. From these measurement results, in a case where the potential of the wire anode 7b is decreased from a potential of +2,400 V of the wire anode 7a, while the gain of the dynode 5 does not change, the gain of the wire anode 7a is improved, and the gain of the wire anode 7b is decreased. This is considered to be because the electrons acquired by the wire anode 7b decrease due to a decrease in the potential of the wire anode 7b, and the electrons acquired by the wire anode 7a increase. For example, in a case where the potential of the wire anode 7b is set to +2,400 V, it is predicted that the gain of the wire anode 7b is twice that of the wire anode 7a, 2/3 of the number of electrons collected by the electron collection unit 7 is acquired by the wire anode 7b, and 1/3 of the number of electrons is acquired by the wire anode 7a. In addition, in a case where the potential of the wire anode 7b is set to +2,380 V, it is predicted that the gain of the wire anode 7a is approximately equal to the gain of the wire anode 7b, approximately half of the number of electrons collected by the electron collection unit 7 is acquired by the wire anode 7b, and approximately half of the remaining electrons are acquired by the wire anode 7a.

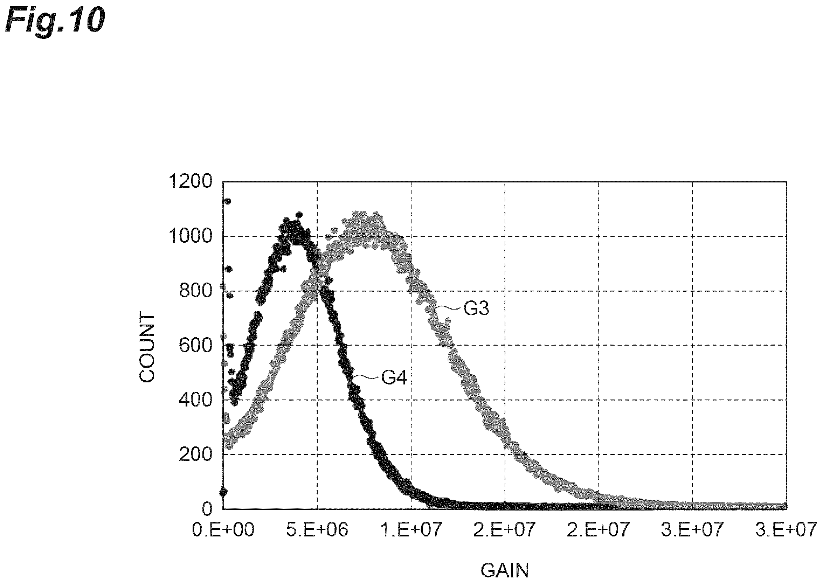

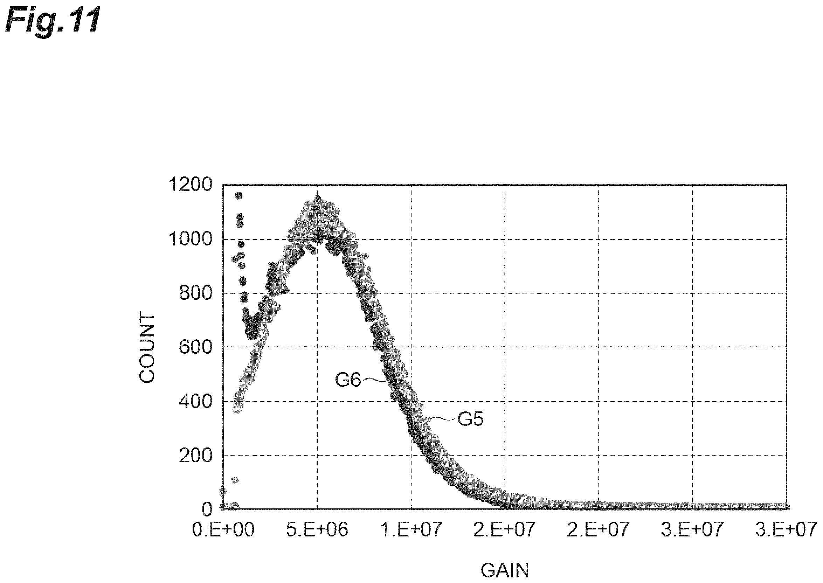

FIG. 10 is a graph illustrating the gain measurement result in a case where the potential of the wire anode 7b is set to +2,400 V in the MCP detector 1, and FIG. 11 is a graph illustrating the gain measurement result in a case where the potential of the wire anode 7b is set to +2,380 V in the MCP detector 1. A graph G3 and a graph G5 each indicate the detection count number of the gain of the wire anode 7b, and a graph G4 and a graph G6 each indicate the detection count number of the gain of the wire anode 7a. From these measurement results, it has been clarified that in a case where the potential of the wire anode 7b is set to be lower than the potential of the wire anode 7a, the gains of the two wire anodes 7a and 7b are likely to coincide with each other, and as a result, distortion in an image representing two-dimensional coordinates of electrons generated by the MCP detector can be reduced.

Although various embodiments of the present invention have been described above, the present invention is not limited to the above-described embodiments, and may be modified or applied to others without changing the gist described in each claim.

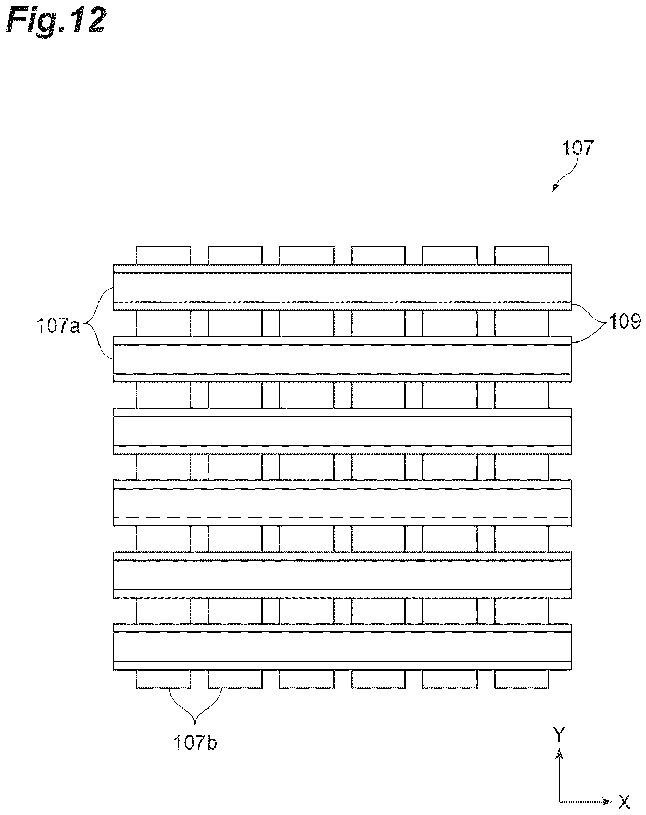

FIG. 12 is a plan view illustrating a configuration of a modification of the electron collection unit. An electron collection unit 107 illustrated in FIG. 12 includes linear anodes 107a constituting metal patterns formed on a plurality of insulators 109 extending in parallel with each other at a predetermined interval along the first direction X, and linear anodes 107b constituting a plurality of metal patterns extending in parallel with each other at a predetermined interval along the second direction Y. A plurality of linear anodes 107a and a plurality of linear anodes 107b are insulated from each other with the insulators 109 interposed therebetween. However, the plurality of linear anodes 107a and the plurality of linear anodes 107b may be spaced to be insulated from each other. The plurality of linear anodes 107a and the plurality of linear anodes 107b are electrically connected to the control unit 9 independently of each other. In the present modification, the signal processing unit 9a of the control unit 9 detects a pulse signal for each of the plurality of linear anodes 107a and the plurality of linear anodes 107b, and measures the distribution of the charge amount for each of lines of the plurality of linear anodes 107a and lines of the plurality of linear anodes 107b on the basis of each of pulse signals, thereby calculating an input position of an electron to the MCP.

In the present embodiment, the case where an electron are to be detected by the MCP detector 1 is exemplified, but in a case where the MCP detector 1 is used as an ion detector, charged particles input to the detector are ions. The input ions are converted into secondary electrons in the input surface of the MCP, and as a result, electrons are output from the output surface of the MCP.

The wire anode 7a and the wire anode 7b may simply intersect each other, and do not need to intersect each other substantially vertically. In addition, the electron collection unit 7 may further include a wire anode 7c (third anode) extending along a plane in a third direction crossing both the wire anode 7a and the wire anode 7b, a potential of the wire anode 7c may be higher than the potential of the wire anode 7b, and the potential of the wire anode 7b may be higher than the potential of the wire anode 7a. In this case, in a case where a plurality of electrons reach the electron collection unit 7 at the same time, these electrons can be detected separately.

In the above-described embodiment, it is suitable that a potential of the dynode is higher than a potential of the output surface, and a potential of the electron collection unit is higher than the potential of the dynode. With this setting, the electrons output from the output surface can efficiently reach the dynode, and the electrons resulting from multiplication by the dynode can be efficiently captured by the electron collection unit. As a result, the detection performance of the MCP detector or the analysis device including the MCP detector can be significantly improved.

In addition, in the above-described embodiment, it is also suitable that a potential of the first anode is higher than a potential of the second anode. In this case, the electrons resulting from multiplication by the dynode can be captured by the first anode and the second anode in a well-balanced manner. As a result, the detection performance of the MCP detector or the analysis device including the MCP detector can be improved in a well-balanced manner.

In addition, in the above-described embodiment, it is also suitable that the first anode includes a thin metal wire extending in a first direction along the plane, and the second anode includes a thin metal wire extending in a second direction intersecting the first direction along the plane. In this case, position information of the input charged particles can be accurately acquired on the basis of two detection signals generated by the first anode and the second anode.

In addition, in the above-described embodiment, it is also suitable that a distance between the second anode and the dynode is set to be larger than a distance between the first anode and the second anode. In this case, the distance between the electron collection unit and the dynode can be ensured, and the withstand voltage can be increased even in a case where the potential difference between the electron collection unit and the dynode is set high in order to increase the gain in the dynode.

In addition, in the above-described embodiment, it is also suitable that the electron collection unit is disposed closer to the dynode than an intermediate position between an intermediate position between the output surface and the dynode, and the dynode. In this way, the incidence efficiency of the electrons output from the output surface of the MCP to the dynode is improved, and the detection performance of the MCP detector can be further improved.

In addition, in the above-described embodiment, it is also suitable that the electron collection unit further includes a support member having insulating properties and supporting the second anode, and the support member is provided outside, as viewed from the output surface, a region where a secondary electron-emitting film is provided on a surface of the dynode. In a case where such a configuration is adopted, the collection efficiency of the electrons resulting from multiplication by the dynode can be improved, and the detection performance of the MCP detector can be further improved.

In addition, in the above-described embodiment, it is also suitable that the electron collection unit further includes a support member having insulating properties and supporting the first anode, and the support member is provided outside, as viewed from the output surface, the region where the secondary electron-emitting film is provided on the surface of the dynode. In a case where such a configuration is adopted, the collection efficiency of the electrons resulting from multiplication by the dynode can be improved, and the detection performance of the MCP detector can be further improved.

The MCP detector of the embodiment is [1] "an MCP detector including: a microchannel plate including an input surface to which a charged particle is input, a multiplier configured to multiply an electron generated in response to an input of the charged particle, and an output surface from which electrons resulting from multiplication by the multiplier are output; a dynode disposed so as to be separated from the output surface and substantially parallel to the output surface, and configured to multiply the electrons output from the output surface, the dynode being in a planar shape; and an electron collection unit disposed between the output surface and the dynode so as to be separated from the output surface and the dynode, and configured to collect electrons resulting from multiplication by the dynode, in which the electron collection unit includes a first anode including a metal wire extending along a plane substantially parallel to the output surface, and a second anode electrically insulated from the first anode, including a metal wire extending along the plane, and disposed between the first anode and the dynode.

The MCP detector of the embodiment may be [2] "the MCP detector according to [1], in which a potential of the dynode is higher than a potential of the output surface, and a potential of the electron collection unit is higher than the potential of the dynode".

The MCP detector of the embodiment may be [3] "the MCP detector according to [2], in which a potential of the first anode is higher than a potential of the second anode".

The MCP detector of the embodiment may be [4] "the MCP detector according to any one of [1] to [3], in which the first anode includes a thin metal wire extending in a first direction along the plane, and the second anode includes a thin metal wire extending in a second direction intersecting the first direction along the plane".

The MCP detector of the embodiment may be [5] "the MCP detector according to any one of [1] to [4], in which a distance between the second anode and the dynode is larger than a distance between the first anode and the second anode".

The MCP detector of the embodiment may be [6] "the MCP detector according to any one of [1] to [5], in which the electron collection unit is disposed closer to the dynode than an intermediate position between an intermediate position between the output surface and the dynode, and the dynode".

The MCP detector of the embodiment may be [7] "the MCP detector according to any one of [1] to [6], in which the electron collection unit further includes a support member having insulating properties and configured to support the second anode, and the support member is provided outside, as viewed from the output surface, a region where a secondary electron-emitting film is provided on a surface of the dynode".

The MCP detector of the embodiment may be [8] "the MCP detector according to any one of [1] to [7], in which the electron collection unit further includes a support member having insulating properties and configured to support the first anode, and the support member is provided outside, as viewed from the output surface, a region where a secondary electron-emitting film is provided on the surface of the dynode".

The analysis device of the embodiment may be [9] "an analysis device including the MCP detector according to any one of [1] to [8]".

## Reference Signs List

| 1 | MCP detector |
| 3 | MCP |
| 3a | Input surface |
| 3b | Output surface |
| 5 | Dynode |
| 7, 107 | Electron collection unit |
| 7a, 107a | Wire anode, linear anode (first anode) |
| 7b, 107b | Wire anode, linear anode (second anode) |
| 9 | Control unit |
| 9a | Signal processing unit |
| 11A, 11B | Multiplier |
| 13 | Thin metal wire (metal wire) |
| e1, e2, e3 | Electron |
| X | First direction |
| Y | Second direction |

## Claims

1. An MCP detector comprising:

   a microchannel plate including an input surface to which a charged particle is input, a multiplier configured to multiply an electron generated in response to an input of the charged particle, and an output surface from which electrons resulting from multiplication by the multiplier are output; a dynode disposed so as to be separated from the output surface and substantially parallel to the output surface, and configured to multiply the electrons output from the output surface, the dynode being in a planar shape; and an electron collection unit disposed between the output surface and the dynode so as to be separated from the output surface and the dynode, and configured to collect electrons resulting from multiplication by the dynode, wherein the electron collection unit includes a first anode including a metal wire extending along a plane substantially parallel to the output surface, and a second anode electrically insulated from the first anode, including a metal wire extending along the plane, and disposed between the first anode and the dynode.

2. The MCP detector according to claim 1, wherein a potential of the dynode is higher than a potential of the output surface, and a potential of the electron collection unit is higher than the potential of the dynode.

3. The MCP detector according to claim 2, wherein a potential of the first anode is higher than a potential of the second anode.

4. The MCP detector according to any one of claims 1 to 3, wherein

   the first anode includes a thin metal wire extending in a first direction along the plane, and the second anode includes a thin metal wire extending in a second direction intersecting the first direction along the plane.

5. The MCP detector according to any one of claims 1 to 4, wherein a distance between the second anode and the dynode is larger than a distance between the first anode and the second anode.

6. The MCP detector according to any one of claims 1 to 5, wherein the electron collection unit is disposed closer to the dynode than an intermediate position between an intermediate position between the output surface and the dynode, and the dynode.

7. The MCP detector according to any one of claims 1 to 6, wherein

   the electron collection unit further includes a support member having insulating properties and configured to support the second anode, and the support member is provided outside, as viewed from the output surface, a region where a secondary electron-emitting film is provided on a surface of the dynode.

8. The MCP detector according to any one of claims 1 to 7, wherein

   the electron collection unit further includes a support member having insulating properties and configured to support the first anode, and the support member is provided outside, as viewed from the output surface, a region where a secondary electron-emitting film is provided on the surface of the dynode.

9. An analysis device comprising the MCP detector according to any one of claims 1 to 8.

Fig.1

Fig.2

(a)

(b)

(c)

EP 4 636 802 A1

**Fig.3**

*Fig.4*

# Fig.5

## Fig.6

Fig.7

EP 4 636 802 A1

**Fig.8**

# Fig.9

*Fig.10*

EP 4 636 802 A1

Fig.11

**Fig.12**

## INTERNATIONAL SEARCH REPORT

International application No.

**PCT/JP2023/045781**

### A. CLASSIFICATION OF SUBJECT MATTER

*H01J 37/244*(2006.01)i; *H01J 43/24*(2006.01)i
FI: H01J37/244; H01J43/24

According to International Patent Classification (IPC) or to both national classification and IPC

### B. FIELDS SEARCHED

Minimum documentation searched (classification system followed by classification symbols)

H01J37/244; H01J43/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | JP 57-196466 A (N.V. PHILIPS' GLOEILAMPENFABRIEKEN) 02 December 1982 (1982-12-02)<br>page 2, lower right column, lines 5-9, page 5, upper right column, lines 6-10, page 6, upper left column, lines 1-12, page 6, lower right column, lines 13-19, fig. 3 | 1-9 |
| A | JP 2017-37782 A (HAMAMATSU PHOTONICS KK) 16 February 2017 (2017-02-16)<br>entire text, all drawings | 1-9 |
| A | JP 2001-273867 A (JEOL LTD.) 05 October 2001 (2001-10-05)<br>entire text, all drawings | 1-9 |

☐ Further documents are listed in the continuation of Box C.  ☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **20 February 2024** | **05 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

**INTERNATIONAL SEARCH REPORT**
Information on patent family members

International application No.

**PCT/JP2023/045781**

| Patent document cited in search report | | | Publication date (day/month/year) | Patent family member(s) | | | Publication date (day/month/year) |
|---|---|---|---|---|---|---|---|
| JP | 57-196466 | A | 02 December 1982 | US | 4568853 | A | |
| | | | | column 1, lines 9-15, column 4, lines 32-37, column 5, lines 44-55, column 6, lines 51-56, fig. 3 | | | |
| | | | | GB | 2098796 | A | |
| | | | | DE | 3217405 | A | |
| | | | | FR | 2506518 | A | |
| JP | 2017-37782 | A | 16 February 2017 | US | 2017/0047213 | A1 | |
| | | | | entire text, all drawings | | | |
| JP | 2001-273867 | A | 05 October 2001 | (Family: none) | | | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S57196466 A